Europäisches Patentamt

European Patent Office

Office européen des brevets

(19)

(11) Veröffentlichungsnummer : **0 428 906 B1**

(12) # EUROPÄISCHE PATENTSCHRIFT

(45) Veröffentlichungstag der Patentschrift :
**25.01.95 Patentblatt 95/04**

(51) Int. Cl.$^6$ : **H01J 37/244, H01J 37/12**

(21) Anmeldenummer : **90120506.2**

(22) Anmeldetag : **25.10.90**

(54) **Korpuskularstrahlgerät.**

(30) Priorität : **21.11.89 DE 3938660**

(43) Veröffentlichungstag der Anmeldung :
**29.05.91 Patentblatt 91/22**

(45) Bekanntmachung des Hinweises auf die
Patenterteilung :
**25.01.95 Patentblatt 95/04**

(84) Benannte Vertragsstaaten :
**DE FR GB IT NL**

(56) Entgegenhaltungen :
**EP-A- 0 191 293**
**PATENT ABSTRACTS OF JAPAN, Band 13, Nr.**
**184 (E-751)[3532], 28. April 1989; & JP-A-1 10**
**561**
**PATENT ABSTRACTS OF JAPAN, Band 8, Nr.**
**81 (E-238)[1518], 13. April 1984; & JP-A-59 838**

(56) Entgegenhaltungen :
**JOURNAL OF VACUUM SCIENCE & TECHNO-**
**LOGY A, Band 4, Nr.2, März/April 1986, Seiten**
**226-229; K. SAITO et al.: "Design method for**
**anelectrostatic einzel lens having an asymme-**
**tric structure"**

(73) Patentinhaber : **ICT Integrated Circuit Testing**
**Gesellschaft für Halbleiterprüftechnik mbH**
**Klausnerring 1a**
**D-85551 Kirchheim (DE)**

(72) Erfinder : **Frosien, Jürgen, Dr.-Ing.**
**An der Ottosäule 18**
**W-8012 Ottobrunn (DE)**
Erfinder : **Spehr, Rainer, Dr.**
**Erfurterstrasse 19**
**W-6105 Ober-Ramstadt (DE)**

(74) Vertreter : **Tetzner, Volkmar, Dr.-Ing. Dr. jur.**
**Van-Gogh-Strasse 3**
**D-81479 München (DE)**

## Beschreibung

Die Erfindung betrifft ein Korpuskularstrahlgerät entsprechend dem Oberbegriff des Anspruches 1.

Geräte der im Oberbegriff des Anspruches vorausgesetzten Art sind aus der Praxis bekannt (vgl. 'Patent Abstracts of Japan', Band 13, Nr. 184).

Korpuskularstrahlgeräte werden heute zur Mikrobearbeitung von Proben, wie beispielsweise zum Abtragen oder Aufbringen von Materialien, sowie in der Analytik eingesetzt. Arbeiten diese Geräte im Abbildungsmodus, wird der Korpuskular-Primärstrahl auf eine Probe fokussiert und die dabei emittierte Sekundärstrahlung detektiert und aufgezeichnet.

Dadurch entsteht eine Abbildung der Probenoberfläche in Abhängigkeit der Sekundärstrahlung. Mit zunehmender Auflösung der Geräte verkleinert sich entsprechend der Korpuskular-Sondendurchmesser, so daß entsprechend der Beziehung

$$i = R * \pi^2/4 * d^2 * \alpha^2$$

der Strom i der Primär-Korpuskularsonde abnimmt. Hierbei bedeuten

R = der Richtstrahlwert der Korpuskularquelle,

d = Sondendurchmesser der Korpuskularsonde

$\alpha$ = zur Erreichung des Sondendurchmessers d zulässiger Aperturwinkel der Objektivlinse.

Infolgedessen verringert sich auch die emittierte Sekundärstrahlung, so daß sich das Signal-Rauschverhältnis S/R verschlechtert. Zur Aufnahme hochwertiger Bilder mit gutem Signal-Rauschverhältnis S/R müssen daher lange Bildaufnahmezeiten verwendet werden.

Bei den bekannten Korpuskularstrahlgeräten werden zum Nachweis der Sekundärstrahlung Detektoren eingesetzt, die zwischen der fokussierenden Objektivlinse und der Probe angeordnet sind. Dabei wird die emittierte Sekundärstrahlung durch eine entsprechend vorgespannte Elektrode von der Probe abgesaugt und auf einen Szintillator beschleunigt. Das dort erzeugte Licht wird in einem Fotomultiplier in ein elektrisches Signal umgewandelt und verstärkt. Andere Detektoren verstärken die abgesaugte Sekundärstrahlung direkt, ohne den Umweg über den Szintillator.

Das Absaugfeld derartiger Anordnungen wirkt sich jedoch nachteilig auf den Primärstrahl aus. Es lenkt einerseits den Primärstrahl ab und bewirkt andererseits eine Sondenaufweitung.

Die mit besonders feinen Sonden arbeitenden, hochauflösenden Geräte müssen mit kleinem Abstand zwischen Objektivlinse und Probe, d.h. mit sehr kurzen Brennweiten arbeiten, um die Linsenfehler ausreichend klein zu halten. Dies wiederum führt beim Absaugen der Sekundärstrahlung mit herkömmlichen Detektoranordnungen zu weiteren Schwierigkeiten. Zum einen nimmt der Durchgriff der Absaugfeldstärke mit kleiner werdendem Arbeitsabstand ab und zum anderen kommt durch die Nähe des elektrostatischen Fokussierfeldes der Objektivlinse ein weiteres, konkurrierendes Absaugfeld hinzu. Beide Tatsachen verschlechtern das Auffangen und Nachweisen der Sekundärstrahlung.

Durch Verwendung der mittleren Elektrode der elektrostatischen Objektivlinse als Absaugelektrode (vgl. 'Patent Abstracts of Japan', Band 13, Nr. 184) kann nahezu die gesamte Sekundärstrahlung auf der mittleren Elektrode aufgefangen werden. Ein dort vorhandenes Szintillatormaterial wandelt die Sekundärstrahlung in Lichtpulse um. Dadurch ist es möglich, Abbildungen der Probe mit optimiertem Signal-Rauschabstand S/R in kürzest möglicher Zeit aufzunehmen.

Mit einer derartigen Anordnung wird zwischen der Objektivlinse und der Probe kein Platz für eine Detektoranordnung benötigt, so daß der Arbeitsabstand und hierdurch die Linsenfehler der Objektivlinse klein gehalten werden können.

Ein weiterer Vorteil dieser bekannten Anordnung liegt in dem rotationssymmetrischen, elektrostatischen Feld der mittleren Elektrode, das keine negativen Auswirkungen auf den Primärstrahl hat, insbesondere keine unbeabsichtigten Ablenkungen oder Sondenaufweitungen.

Bei der gattungsbildenden Vorrichtung gemäß 'Patent Abstracts of Japan', Band 13, Nr. 184, besitzen die drei Elektroden der Objektivlinse gleichen Öffnungsdurchmesser. Die als Szintillator ausgebildete mittlere Elektrode ist dabei über Lichtleiter mit dem Detektor verbunden.

Der Erfindung liegt die Aufgabe zugrunde ein gattungsgemäßes Korpuskularstrahlgerät so auszubilden, daß die am Szintillator durch die Sekundärstrahlung erzeugte Lichtenergie mit möglichst geringen Verlusten zum Detektor übertragen wird.

Diese Aufgabe wird erfindungsgemäß durch die kennzeichnenden Merkmale der Ansprüche 1 bis 3 gelöst.

Weitere Merkmale der Erfindung sind Gegenstand der Unteransprüche und werden im Zusammenhang mit der Zeichnung und der folgenden Beschreibung näher erläutert.

In der Zeichnung zeigen

Fig.1 eine schematische Schnittdarstellung eines Korpuskularstrahlgerätes,

Fig. 2 eine Schnittdarstellung durch ein erstes Ausführungsbeispiel einer Objektivlinse und einer lichtübertragenden Einheit,

Fig. 3     eine Schnittdarstellung durch ein weiteres Ausführungsbeispieleiner Objectivlinse,

Fig. 4     eine Schnittdarstellung durch ein weiteres Ausführungsbeispiel einer Objectivlinse.

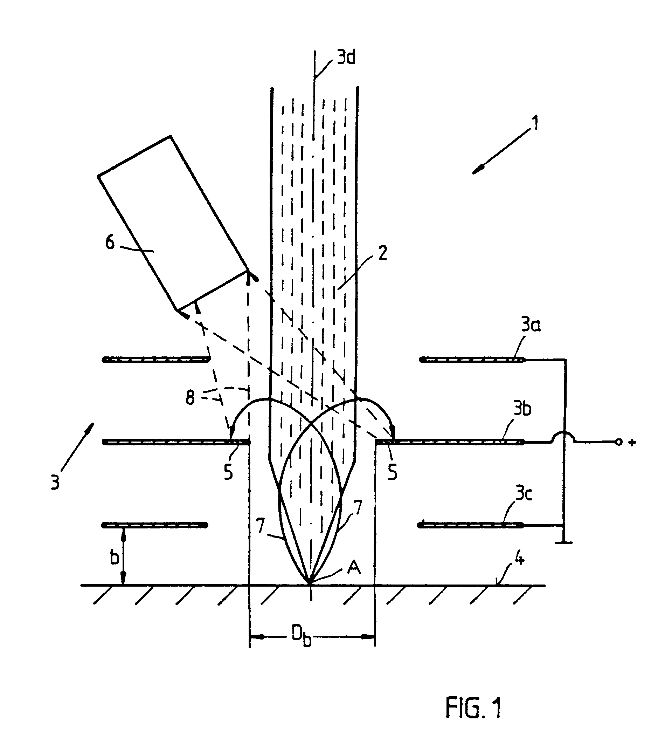

In Fig.1 ist ein Korpuskularstrahlgerät 1 schematisch dargestellt. Es enthält eine nicht dargestellte Einrichtung zur Erzeugung eines Korpuskular-Primärstrahls 2, der durch eine elektrostatische Objectivlinse 3 auf eine Probe 4 fokussiert wird. Der Primärsträhl 2 kann dabei je nach Anwendung durch einen Ionenstrahl oder durch einen Elektronenstrahl gebildet werden.

Die elektrostatische Objectivlinse 3 weist drei Elektroden 3a, 3b und 3c auf, die als ebene Ringscheiben ausgebildet sind. Die drei Elektroden 3a, 3b und 3c sind in Richtung des Primärstrahls 2 hintereinander angeordnet, wobei die Achse des Primärstrahls 2 mit der Achse 3d der Objektivlinse 3 zusammenfällt.

Eine die Öffnung der mittleren Elektrode 3b umschließende schmale Ringzone dieser Elektrode ist zumindest auf der der Probe 4 abgewandten Seite mit Szintillatormaterial versehen, das einen Szintillator 5 bildet. Über der elektrostatischen Objektivlinse 3 ist ein lichtempfindlicher Detektor 6, wie beispielsweise ein Fotomultuplier, angeordnet, der auf den Szintillator 5 der mittleren Elektrode 3b ausgerichtet ist.

Der in Fig.1 dargestellte, durch die Objektivlinse 3 fokussierte positive Ionenstrahl 2 erzeugt im Auftreffpunkt A der Probe 4 eine Sekundärstrahlung. Bei der Objektivlinse sind die beiden äußeren Elektroden 3a und 3c auf Masse gelegt, während die mittlere Elektrode 3b ein stark positives Potential aufweist. Dadurch werden die negativen Teilchen der Sekundärstrahlung, wie beispielsweise Elektronen, auf die mittlere Elektrode 3b und damit auf den Szintillator 5 beschleunigt (Zeile 7). Die auf dem Szintillator 5 auftreffende Sekundärstrahlung erzeugt Lichtpulse, die in den Fotomultuplier 6 gelangen (gestrichelte Pfeile 8) und dort in elektrische Signale umgewandelt und verstärkt werden.

Für die Beschleunigung der Sekundärstrahlung auf den Szintillator 5 wird keine zusätzliche Spannung benötigt, da der Szintillator 5 durch seine Ankoppelung an die mittlere Elektrode 3b ein ausreichend hohes Potential besitzt.

Da sich der Szintillator 5 innerhalb der Objektivlinse 3 befindet, kann der Arbeitsabstand b zwischen Objektivlinse 3 und Probe 4 klein gehalten werden, so daß hierdurch auch die Linsenfehler gering bleiben. Zudem können durch das rotationssymmetrische Feld der mittleren Elektrode 3b einerseits eine ungewollte Ablenkung und andererseits eine Sondenaufweitung im Auftreffpunkt A vermieden werden.

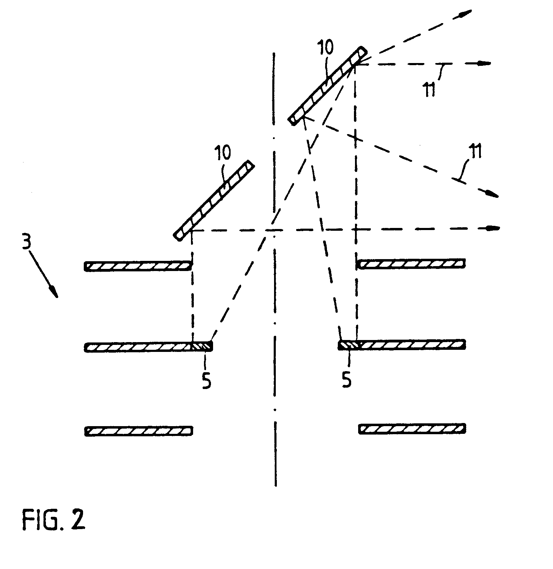

In Fig.2 ist die lichtübertragende Einheit durch ein über der Objektivlinse 3 angeordnetes Spiegelsystem 10 verwirklicht. Die im Szintillator 5 erzeugten Lichtpulse werden gemäß den gestrichelten Pfeilen 11 am Spiegelsystem 10 abgelenkt und dem Fotomultuplier 6 zugeführt.

Außer den bereits oben beschriebenen lichtübertragenden Einheiten, wie Spiegelsystem 10, kann auch ein Linsensystem verwendet werden.

Bei der in Fig.1 dargestellten Objektivlinse 3 weist die mittlere Elektrode 3b einen kleineren Öffnungsdurchmesser $D_b$ auf als die beiden symmetrisch zur mittleren Elektrode 3b angeordneten und ausgebildeten Elektroden 3a und 3c.

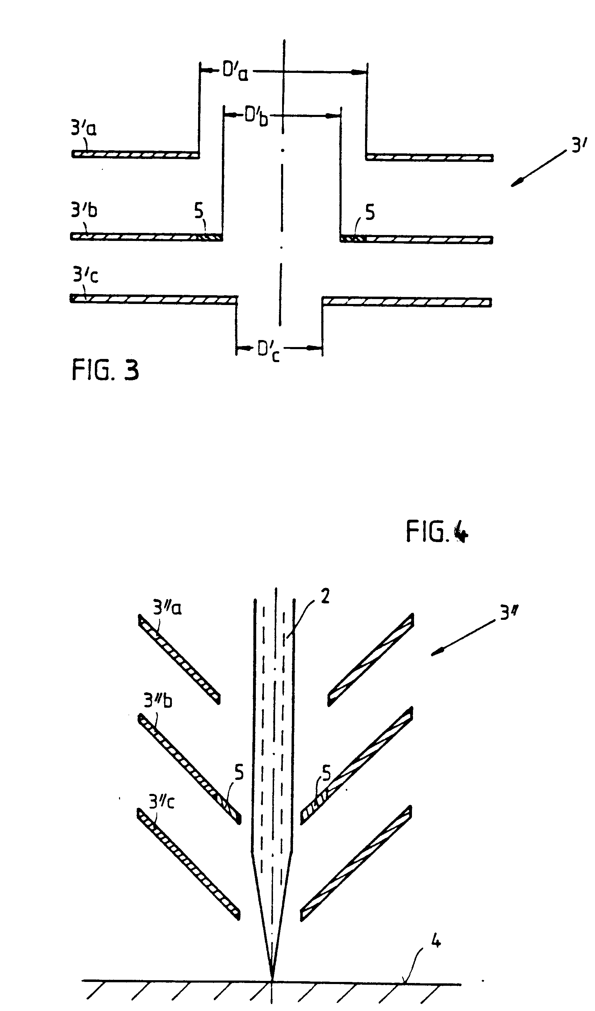

In Fig.3 ist ebenfalls eine planare, elektrostatische Objektivlinse dargestellt, die jedoch einen asymmetrischen Elektrodenaufbau aufweist. Die der Probe zugewandte äußere Elektrode 3'c der Objektivlinse 3' weist einen kleineren Öffnungsdurchmesser $D'_c$ auf als die beiden anderen Elektroden 3'a und 3'b. Der Durchmesser $D'_b$ der mittleren Elektrode 3'b ist wiederum kleiner als der Durchmesser $D'_a$ der der Probe abgewandten Elektrode 3'a.

In Fig.4 ist als weiteres Ausführungsbeispiel eine konische elektrostatische Objektivlinse 3" dargestellt. Hierbei sind die Elektroden 3"a, 3"b und 3"c der Objektivlinse 3" als sich in Richtung des Primärstrahles 2 verjüngende Konuselemente ausgebildet.

Alle Arten von elektrostatischen Objektivlinsen sind denkbar, wie beispielsweise Einzellinsen, flache und konische Bauformen sowie Immersionslinsen.


## Patentansprüche

1.     Korpuskularstrahlgerät, wie Ionenstrahlgerät oder Elektronenstrahlgerät, enthaltend

       a) eine Einrichtung zur Erzeugung eines Korpuskular-Primärstrahls (2),

       b) eine den Primärstrahl (2) auf eine Probe (4) fokussierende, elektrostatische Objektivlinse (3), die drei in Strahlrichtung hintereinander angeordnete, rotationssymmetrische Elektroden (3a, 3b, 3c) enthält, wobei die Achse des Primärstrahls (2) mit der Achse (3d) der Objektivlinse (3) zusammenfällt,

       c) eine die auf der Probe (4) am Auftreffpunkt (A) des Primärstrahls (2) emittierte Sekundärstrahlung absaugende Einrichtung,

       d) einen im Strahlengang der Sekundärstrahlung angeordneten Szintillator (5), der durch die mittlere Elektrode (3b) der Objektivlinse (3) gebildet wird und mit einem lichtempfindlichen Detektor (6) verbunden ist,

gekennzeichnet durch folgende Merkmale:

e) der Szintillator (5) ist mit dem Detektor (6) über ein Spiegelsystem (10) oder ein Linsensystem verbunden;

f) die mittlere Elektrode (3b) der Objektivlinse (3) weist einen kleineren Öffnungsdurchmesser ($D_b$) als die beiden symmetrisch zur mittleren Elektrode (3b) angeordneten und ausgebildeten Elektroden (3a, 3c) auf.

2. Korpuskularstrahlgerät, wie Ionenstrahlgerät oder Elektronenstrahlgerät, enthaltend

a) eine Einrichtung zur Erzeugung eines Korpuskular-Primärstrahls,

b) eine den Primärstrahl auf eine Probe fokussierende, elektrostatische Objektivlinse (3′), die drei in Strahlrichtung hintereinander angeordnete, rotationssymmetrische Elektroden (3′a, 3′b, 3′c) enthält, wobei die Achse des Primärstrahls mit der Achse der Objektivlinse (3′) zusammenfällt,

c) eine die auf der Probe am Auftreffpunkt des Primärstrahls emittierte Sekundärstrahlung absaugende Einrichtung,

d) einen im Strahlengang der Sekundärstrahlung angeordneten Szintillator (5), der durch die mittlere Elektrode (3′b) der Objektivlinse (3′) gebildet wird und mit einem lichtempfindlichen Detektor verbunden ist,

gekennzeichnet durch folgende Merkmale:

e) der Szintillator (5) ist mit dem Detektor über ein Spiegelsystem oder ein Linsensystem verbunden;

f) die der Probe zugewandte äußere Elektrode (3′c) der Objektivlinse (3′) weist einen kleineren Öffnungsdurchmesser ($D′_c$) als die beiden anderen Elektroden (3′a, 3′b) auf, während die mittlere Elektrode (3′b) einen kleineren Öffnungsdurchmesser ($D′_b$) als die der Probe abgewandte Elektrode (3′a) besitzt.

3. Korpuskularstrahlgerät, wie Ionenstrahlgerät oder Elektronenstrahlgerät, enthaltend

a) eine Einrichtung zur Erzeugung eines Korpuskular-Primärstrahls (2),

b) eine den Primärstrahl (2) auf eine Probe fokussierende, elektrostatische Objektivlinse (3″), die drei in Strahlrichtung hintereinander angeordnete, rotationssymmetrische Elektroden (3″a, 3″b, 3″c) enthält, wobei die Achse des Primärstrahls (2) mit der Achse der Objektivlinse (3″) zusammenfällt,

c) eine die auf der Probe am Auftreffpunkt des Primärstrahls (2) emittierte Sekundärstrahlung absaugende Einrichtung,

d) einen im Strahlengang der Sekundärstrahlung angeordneten Szintillator (5), der durch die mittlere Elektrode (3″b) der Objektivlinse (3″) gebildet wird und mit einem lichtempfindlichen Detektor verbunden ist,

gekennzeichnet durch folgende Merkmale:

e) der Szintillator (5) ist mit dem Detektor übei ein Spiegelsystem oder ein Linsensystem verbunden;

f) die Elektroden (3″a, 3″b, 3″c) der Objektivlinse (3″) sind als sich in Richtung des Korpuskular-Primärstrahls (2) verjüngende Konuselemente ausgebildet.

4. Gerät nach Anspruch 1, 2 oder 3, dadurch gekennzeichnet, daß der Korpuskular-Primärstrahl (2) durch einen Ionenstrahl gebildet wird.

5. Gerät nach Anspruch 1, 2 oder 3, dadurch gekennzeichnet, daß der Korpuskular-Primärstrahl (2) durch einen Elektronenstrahl gebildet wird.

6. Gerät nach Anspruch 1 oder 2, dadurch gekennzeichnet, daß die Elektroden (3a, 3b, 3c; 3′a, 3′b, 3′c) der Objektivlinse (3; 3′) als ebene Ringscheiben ausgebildet sind.

7. Gerät nach Anspruch 1, 2 oder 3, dadurch gekennzeichnet, daß eine die Öffnung der mittleren Elektrode (3b, 3′b, 3″b) umschließende schmale Ringzone der mittleren Elektrode zumindest auf der der Probe abgewandten Seite mit Szintillationsmaterial versehen ist und den Szintillator (5) bildet.

Claims

1. Corpuscular beam device, such as an ion beam device or an electron beam device, containing

a) an arrangement for producing a primary corpuscular beam (2),

4

b) an electrostatic objective lens (3) which focusses the primary beam (2) onto a sample (4) and contains three rotationally symmetrical electrodes (3a, 3b, 3c) arranged behind one another in the beam direction, the axis of the primary beam (2) coinciding with the axis (3d) of the objective lens (3),

c) an arrangement which draws off the secondary radiation emitted on the sample (4) at the point of impact (A) of the primary beam (2),

d) a scintillator (5) arranged in the beam path of the secondary radiation, the scintillator being formed by the central electrode (3b) of the objective lens (3) and connected to a light-sensitive detector (6), characterised by the following features:

e) the scintillator (5) is connected to the detector (6) by way of a mirror system (10) or a lens system;

f) the central electrode (3b) of the objective lens (3) has a smaller opening diameter ($D_b$) than the two electrodes (3a, 3c) which are arranged and constructed symmetrically with respect to the central electrode (3b).

2. Corpuscular beam device, such as an ion beam device or an electron beam device, containing

a) an arrangement for producing a primary corpuscular beam,

b) an electrostatic objective lens (3′) which focusses the primary beam onto a sample and contains three rotationally symmetrical electrodes (3′a, 3′b, 3′c) arranged behind one another in the beam direction, the axis of the primary beam coinciding with the axis of the objective lens (3′),

c) an arrangement which draws off the secondary radiation emitted on the sample at the point of impact of the primary beam,

d) a scintillator (5) arranged in the beam path of the secondary radiation, the scintillator being formed by the central electrode (3′b) of the objective lens (3′) and connected to a light-sensitive detector, characterised by the following features:

e) the scintillator (5) is connected to the detector by way of a mirror system or a lens system;

f) the central electrode (3′c) of the objective lens (3′) facing the sample has a smaller opening diameter ($D′_c$) than the two other electrodes (3′a, 3′b), whilst the central electrode (3′b) has a smaller opening ($D′_b$) than the electrode (3′a) facing away from the sample.

3. Corpuscular beam device, such as an ion beam device or an electron beam device, containing

a) an arrangement for producing a primary corpuscular beam,

b) an electrostatic objective lens (3″) which focusses the primary beam (2) onto a sample and contains three rotationally symmetrical electrodes (3″a, 3″b, 3″c) arranged behind one another in the beam direction, the axis of the primary beam (2) coinciding with the axis of the objective lens (3″),

c) an arrangement which draws off the secondary radiation emitted on the sample at the point of impact of the primary beam (2),

d) a scintillator (5) arranged in the beam path of the secondary radiation, the scintillator being formed by the central electrode (3″b) of the objective lens (3″) and connected to a light-sensitive detector, characterised by the following features:

e) the scintillator (5) is connected to the detector by way of a mirror system or a lens system;

f) the electrodes (3″a, 3″b, 3″c) of the objective lens (3″) are constructed as cone elements which taper in the direction of the primary corpuscular beam (2).

4. Device as claimed in Claim 1, 2 or 3, characterised in that the primary corpuscular beam (2) is formed by an ion beam.

5. Device as claimed in Claim 1, 2 or 3, characterised in that the primary corpuscular beam (2) is formed by an electron beam.

6. Device as claimed in Claim 1 or 2, characterised in that the electrodes (3a, 3b, 3c; 3′a, 3′b, 3′c) of the objective lens (3; 3′) are constructed as flat annular discs.

7. Device as claimed in claim 1, 2 or 3, characterised in that a narrow annular zone of the central electrode surrounding the opening of the central electrode (3b, 3′b, 3″b) is provided at least on the side facing away from the sample with scintillation material and forms the scintillator (5).

**Revendications**

1. Canon corpusculaire tel que canon ionique ou canon électronique, comprenant

a) un dispositif de génération d'un faisceau corpusculaire primaire (2),

b) une lentille électrostatique d'objectif (3) qui focalise le faisceau primaire (2) sur un échantillon (4) et qui comporte trois électrodes (3a, 3b, 3c) qui sont symétriques de révolution et sont disposées à la suite les unes des autres dans le sens du faisceau, l'axe du faisceau primaire (2) coïncidant avec l'axe (3d) de la lentille (3) de l'objectif,

c) un dispositif de pompage du rayonnement secondaire émis sur l'échantillon (4) au point d'impact (A) du faisceau primaire (2),

d) un scintillateur (5) qui est disposé dans la marche du faisceau du rayonnement secondaire, qui est formé par l'électrode médiane (3b) de la lentille (3) de l'objectif et qui est relié à un détecteur photosensible (6),

     caractérisé par les particularités suivantes :

e) le scintillateur (5) est relié au détecteur (6) par un système à miroirs (10) ou un système de lentilles ;

f) l'électrode médiane (3b) de la lentille de l'objectif (3) présente un diamètre d'ouverture ($D_b$) qui est plus petit que celui des deux électrodes (3a, 3c) disposées et réalisées symétriquement par rapport à l'électrode médiane (3b).

2.   Canon corpusculaire tel que canon ionique ou canon électronique, comprenant

a) un dispositif de génération d'un faisceau corpusculaire primaire,

b) une lentille électrostatique d'objectif (3') qui focalise le faisceau primaire sur un échantillon et qui comporte trois électrodes (3'a, 3'b, 3'c) qui sont symétriques de révolution et sont disposées les unes derrière les autres dans le sens du faisceau, l'axe du faisceau primaire coïncidant avec l'axe de la lentille (3') de l'objectif,

c) un dispositif de pompage du rayonnement secondaire émis sur l'échantillon au point d'impact du faisceau primaire,

d) un scintillateur (5) qui est disposé dans la marche du faisceau du rayonnement secondaire, qui est formé par l'électrode médiane (3'b) de la lentille (3') de l'objectif et qui est relié à un détecteur photosensible,

     caractérisé par les particularités suivantes :

e) le scintillateur (5) est relié au détecteur par un système à miroirs ou un système de lentilles ;

f) l'électrode extérieure (3'c) de la lentille de l'objectif (3') qui est tournée vers l'échantillon a un diamètre d'ouverture ($D'_c$) qui est plus petit que celui des deux électrodes (3'a, 3'c), tandis que l'électrode médiane (3'b) a un diamètre d'ouverture ($D'_b$) qui est plus petit que celui de l'électrode (3'a) qui est tournée à l'opposé de l'échantillon.

3.   Canon corpusculaire tel que canon ionique ou canon électronique, comprenant

a) un dispositif de génération d'un faisceau corpusculaire primaire (2),

b) une lentille électrostatique d'objectif (3″) qui focalise le faisceau primaire (2) sur un échantillon et qui comprend trois électrodes (3″a, 3″b, 3″c) qui sont symétriques de révolution et disposées les unes à la suite des autres dans le sens du faisceau, l'axe du faisceau primaire (2) coïncidant avec l'axe de la lentille (3″) de l'objectif,

c) un dispositif de pompage du rayonnement secondaire émis sur l'échantillon au point d'impact du faisceau primaire (2),

d) un scintillateur qui est disposé dans la marche du faisceau du rayonnement secondaire, qui est formé de l'électrode médiane (3″b) de la lentille (3″) de l'objectif et qui est relié à un détecteur photosensible,

     caractérisé par les particularités suivantes :

e) le scintillateur (5) est relié au détecteur par un système de miroirs ou un système de lentilles ;

f) les électrodes (3″a, 3″b, 3″c) de la lentille (3″) de l'objectif sont conformées en éléments coniques qui se rétrécissent dans le sens du faisceau corpusculaire primaire (2).

4.   Appareil selon la revendication 1, 2 ou 3, caractérisé en ce que le faisceau corpusculaire primaire (2) est formé d'un faisceau ionique.

5.   Appareil selon la revendication 1, 2 ou 3, caractérisé en ce que le faisceau corpusculaire primaire (2) est formé d'un faisceau électronique.

6.   Appareil selon la revendication 1 ou 2, caractérisé en ce que les électrodes (3a, 3b, 3c 3'a, 3'b, 3'c) de la lentille (3 ; 3') de l'objectif sont conformées en disques annulaires plans.

7.   Appareil selon la revendication 1, 2 ou 3, caractérisé en ce qu'une zone annulaire étroite de l'électrode

6

médiane qui entoure l'ouverture de l'électrode médiane (3b, 3'b, 3″b) est munie d'une matière de scintillation au moins sur le côté tourné à l'opposé de l'échantillon et forme le scintillateur (5).

FIG. 1

FIG. 2

FIG. 3

FIG. 4